(19) Europäisches Patentamt / European Patent Office / Office européen des brevets

(11) **EP 4 492 075 B1**

(12) **EUROPEAN PATENT SPECIFICATION**

(45) Date of publication and mention
of the grant of the patent:
**15.07.2026 Bulletin 2026/29**

(21) Application number: **23889187.3**

(22) Date of filing: **09.11.2023**

(51) International Patent Classification (IPC):
*G01R 31/392* (2019.01)  *G01R 31/3835* (2019.01)
*G01R 31/56* (2020.01)  *G01R 19/12* (2006.01)
*H01M 4/36* (2006.01)  *H01M 10/48* (2006.01)
*H01M 10/052* (2010.01)  *H01M 4/58* (2010.01)
*H01M 4/583* (2010.01)  *H01M 4/587* (2010.01)
*H01M 10/0525* (2010.01)  *H01M 10/42* (2006.01)

(52) Cooperative Patent Classification (CPC):
H01M 10/052; G01R 31/392; H01M 4/36;
H01M 4/5825; H01M 4/583; H01M 4/587;
H01M 10/0525; H01M 10/42; H01M 10/48;
Y02E 60/10

(86) International application number:
**PCT/KR2023/018007**

(87) International publication number:
**WO 2024/101930 (16.05.2024 Gazette 2024/20)**

(54) **BATTERY MANAGEMENT SYSTEM, BATTERY PACK COMPRISING SAME, AND METHOD OF DIAGNOSING DETERIORATION OF SECONDARY BATTERY**

BATTERIEVERWALTUNGSSYSTEM, BATTERIEPACK DAMIT UND VERFAHREN ZUR DIAGNOSE DER VERSCHLECHTERUNG EINER SEKUNDÄRBATTERIE

SYSTÈME DE GESTION DE BATTERIE, BATTERIE LE COMPRENANT, ET PROCÉDÉ DE DIAGNOSTIC DE DÉTÉRIORATION DE BATTERIE SECONDAIRE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **11.11.2022 KR 20220150244**

(43) Date of publication of application:
**15.01.2025 Bulletin 2025/03**

(73) Proprietor: **LG Energy Solution, Ltd.**
**Seoul 07335 (KR)**

(72) Inventors:
• **SUNG, Jin Su**
**Daejeon 34122 (KR)**
• **KIM, Ki Woong**
**Daejeon 34122 (KR)**
• **AN, In Gu**
**Daejeon 34122 (KR)**
• **KWON, O Jong**
**Daejeon 34122 (KR)**
• **CHOI, Jung Hun**
**Daejeon 34122 (KR)**
• **KIM, Kwang Jin**
**Daejeon 34122 (KR)**
• **LEE, Da Young**
**Daejeon 34122 (KR)**
• **PARK, Jeong Hwa**
**Daejeon 34122 (KR)**
• **HAN, Geum Jae**
**Daejeon 34122 (KR)**

(74) Representative: **Hoffmann Eitle**
**Patent- und Rechtsanwälte PartmbB**
**Arabellastraße 30**
**81925 München (DE)**

(56) References cited:
EP-A1- 2 527 855      EP-A1- 3 989 330
KR-A- 20120 074 848    KR-A- 20170 095 735
KR-A- 20210 099 939    KR-A- 20210 099 939

KR-B1- 100 911 315     US-A1- 2020 018 799

KR-B1- 100 911 315     US-A1- 2020 018 799

**Description**

[Technical Field]

This application claims the benefit of priority based on Korean Patent Application No 10-2022-0150244, filed on November 11, 2022.

The present invention relates to a battery management system for diagnosing the degradation of secondary batteries equipped with a positive electrode including lithium iron phosphate, a battery pack including the same, and a method for diagnosing the degradation of secondary batteries.

[Background Technology of the Invention]

Recently, with the rapidly increasing demand for portable electronics such as laptops, video cameras, and portable phones, as well as the development of electric vehicles, energy storage batteries, robots, and satellites, research on high-performance batteries that can be repeatedly charged and discharged has been ongoing.

Currently, commercially available batteries include nickel-cadmium batteries, nickel-hydrogen batteries, nickel-zinc batteries, and lithium secondary batteries, which have been gaining attention for their ability to charge and discharge freely with little memory effect, very low self-discharge rate, and high energy density compared to nickel-based batteries.

As these lithium secondary batteries are repeatedly charged and discharged, they undergo degradation, which is a reduction in capacity and energy. As the battery degrades, its cycling performance, such as capacity retention rate, decreases, reducing the lifespan of the battery and decreasing its usability. Therefore, it is necessary to diagnose whether the secondary battery in use is degraded or not, and to repair the battery if it is diagnosed as degraded.

Various techniques exist for diagnosing the state of degradation of a battery. For example, the following patent discloses utilizing Differential Voltage Analysis ("DVA") to obtain information about a degradation state of a battery from the Q-dV/dQ curve of the battery. The Q-dV/dQ curve can be represented as a graph with a Q-axis and a dV/dQ-axis, where Q is the amount of storage, V is the voltage, dV is the amount of change in V over a predetermined time, dQ is the amount of change in Q over the predetermined time, and dV/dQ is the ratio of dV to dQ.

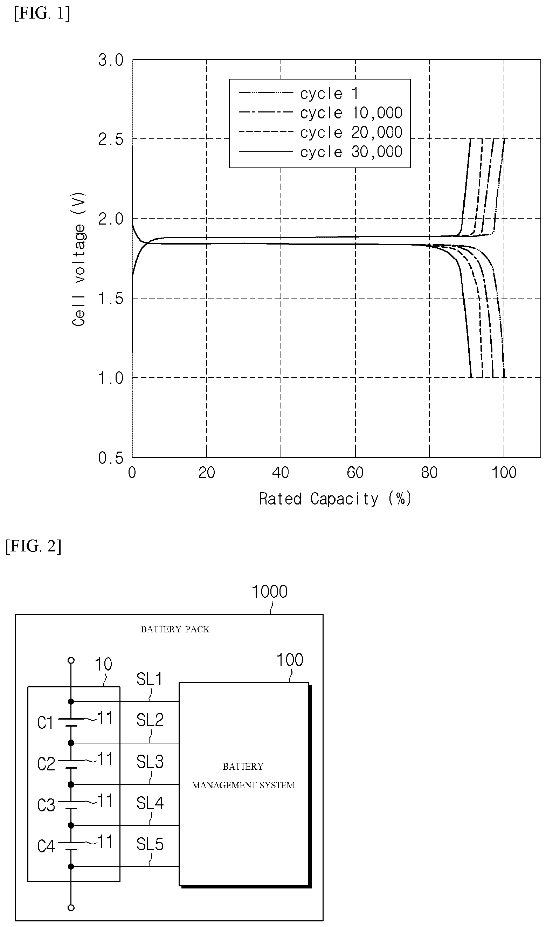

However, these techniques are not suitable for determining the degradation of a secondary battery having a positive electrode with lithium iron phosphate as the positive electrode active material. FIG. 1 is a graph illustrating the voltage according to the capacity of a secondary battery having a positive electrode with lithium iron phosphate as the positive electrode active material. Referring to FIG. 1, it can be seen that due to the structural features of lithium iron phosphate, a secondary battery including lithium iron phosphate as the positive electrode active material exhibits a flat voltage even the charge and discharge capacity varies. This phenomenon is due to the stability of the olivine structure of lithium phosphate and the similarity of the crystal structures of $LiFePO_4$ in the discharged state and $FePO_4$ in the charged state. Therefore, it is not possible to determine whether or not the secondary battery including lithium phosphate as the positive electrode active material is degraded or the degree of degradation based on the differential voltage analysis method, so it is necessary to develop a technology for this.

EP 3 989 330 A1 discloses an apparatus for diagnosing a degree of degradation of a battery including a measuring unit configured to measure a voltage of each of a plurality of battery cells in each of a plurality of cycles where charging and discharging is performed and output a plurality of voltage information about the plurality of measured voltages and a control unit configured to receive the plurality of voltage information, calculate a voltage deviation of each cycle for each battery cell based on a reference voltage of each of the plurality of battery cells, select a cycle section satisfying a predetermined condition for each of the plurality of battery cells based on the calculated voltage deviation, calculate a voltage deviation change rate corresponding to each of the plurality of selected cycle sections, and diagnose a relative degree of degradation of the plurality of battery cells based on the plurality of calculated voltage deviation change rates.

[Description of the Invention]

[Technical Problem]

The present invention aims to provide a battery management system and method for diagnosing the degradation due to repeated charging and discharging in a secondary battery including lithium iron phosphate as a positive electrode active material, as well as a battery pack including the same.

[Technical Solution]

The present invention provides a battery management system for diagnosing the degradation of secondary batteries equipped with a positive electrode including lithium iron phosphate as a positive electrode active material, including: a sensing part configured to measure the voltage and open circuit voltage of a secondary battery; a memory part configured to store the open circuit voltage measured by the sensing part; and a control part configured to determine that the secondary battery is degraded if the amount of change in the open circuit voltage due to charge/discharge cycles of the secondary battery satisfies Condition 1 below for at least five charge/discharge cycles.

[Condition 1]

$$V_{n-1} - V_n < 0.002V$$

(In Condition 1, $V_{n-1}$ represents the open circuit voltage measured during the (n-1)th charge-discharge cycle, $V_n$ represents the open circuit voltage measured during the nth charge/discharge cycle, and n represents a random integer)

In an exemplary embodiment of the present invention, the sensing part may be configured to measure the voltage of the secondary battery during discharge, and to measure the open circuit voltage of the secondary battery each time the measured voltage reaches a reference discharge voltage.

In an exemplary embodiment of the present invention, the sensing part may be configured to measure the open circuit voltage of the secondary battery during the rest period after reaching the reference discharge voltage.

In an exemplary embodiment of the present invention, the sensing part may be configured to measure the open circuit voltage of the secondary battery at the end of each charge/discharge cycle.

A battery management system according to another exemplary embodiment of the present invention may further include a switching part that turns the electrical connection between the secondary battery and the charger on and off.

The present invention provides a battery pack including: the battery management system and a plurality of secondary batteries.

In an exemplary embodiment of the present invention, the secondary battery may include a graphite-based negative electrode active material as the negative electrode active material, comprising 50 to 100% by weight of the total weight of the negative electrode active material included in the negative electrode.

A method for diagnosing the degradation of a secondary battery according to the present invention is a method for diagnosing the degradation of a secondary battery equipped with a positive electrode including lithium iron phosphate as a positive electrode active material, including: (A) a process of repeatedly charging and discharging a secondary battery, while measuring the voltage when the secondary battery discharges and measuring the open circuit voltage of the secondary battery whenever the measured voltage reaches a reference discharge voltage; and (B) a process of determining that a secondary battery is degraded when the change in open circuit voltage satisfies Condition 1 below for at least five charge/discharge cycles.

[Condition 1]

$$V_{n-1} - V_n < 0.002V$$

(In Condition 1, $V_{n-1}$ represents the open circuit voltage measured during the (n-1)th charge-discharge cycle, $V_n$ represents the open circuit voltage measured during the nth charge/discharge cycle, and n represents a random integer)

In an exemplary embodiment of the present invention, the process (A) may include measuring the open circuit voltage of the secondary battery during the rest period after reaching the reference discharge voltage.

In an exemplary embodiment of the present invention, the process (A) may include measuring the open circuit voltage of the secondary battery at the end of each charge/discharge cycle.

[Advantageous Effects]

In a secondary battery equipped with a positive electrode including lithium iron phosphate as the positive electrode active material, by using the characteristic that the potential difference of the negative electrode is showed as the open circuit voltage of the secondary battery, there is an effect of diagnosing the degradation of the secondary battery from the amount of change in the open circuit voltage as the charge/discharge cycle progresses.

[Brief Description of the Drawings]

FIG.1 is a graph illustrating the voltage according to the capacity for a secondary battery having a positive electrode with lithium iron phosphate as a positive electrode active material.

FIG. 2 is a diagram illustrating an exemplary configuration of a battery pack including a battery management system according to an exemplary embodiment of the present invention.

FIG.3 is a block diagram schematically illustrating a battery management system according to an exemplary embodiment of the present invention.

FIG. 4 is a graph illustrating an exemplary measurement of open circuit voltage over a charge/discharge cycle calculated by a battery management system 100 according to an exemplary embodiment of the present invention.

FIG. 5 is a schematic diagram of a battery pack including a battery management system according to another exemplary embodiment of the present invention.

FIG. 6 is a flowchart illustrating an exemplary method for diagnosing degradation of a secondary battery according to another exemplary embodiment of the present invention.

[Reference numerals]

1: ELECTRICAL SYSTEM
2: UPPER-LEVEL CONTROLLER
10: BATTERY MODULE
11: SECONDARY BATTERY
1000, 2000: BATTERY PACK
100, 200: BATTERY MANAGEMENT SYSTEM
110, 210: SENSING PART
120, 220: MEMORY PART
130, 230: CONTROL PART
240: SWITCHING PART
250: INTERFACE PART

[Best Mode for Carrying out the Invention]

Hereinafter, the preferred embodiments of the present invention will be described in detail with reference to the attached drawings. Prior to this, the terms and words used in this specification and claims should not be construed in a limited or merely dictionary sense, but should be interpreted according to the meaning and concept consistent with the technical scope of the present invention, based on the principle that the inventor is entitled to define terms in a way that best describes his invention, within the scope of the appended claims.

Therefore, it should be understood that the embodiments described in this specification and the configurations illustrated in the drawings are merely the most preferred embodiments of the present invention and do not represent all the technical scope of the present invention, so it should be understood that various modifications that could substitute for these embodiments within the scope of the appended claims may exist at the time of filing this application.

Throughout the specification, when a part is said to "include" a component, it is meant to be inclusive of other components, not exclusive of other components, unless specifically noted to the contrary. Also, terms such as <control unit> in the specification mean a unit that handles at least one function or operation, which may be implemented in hardware, software, or a combination of hardware and software.

Furthermore, throughout the specification, when a part is said to be "connected" to another part, this includes not only when it is "directly connected" but also when it is "indirectly connected" with another element in between.

FIG. 2 is a diagram of an exemplary configuration of a battery pack including a battery management system according to an exemplary embodiment of the present invention.

Referring to FIG. 2, the battery pack 1000 may be provided for installation in an electrical system (e.g., an electric vehicle). The battery management system 100 according to the present invention may be electrically connected to the battery module 10, which includes a plurality of secondary batteries 11, to diagnose the condition of each of the plurality of secondary batteries.

Furthermore, the battery management system 100 according to the present invention may be included in the battery pack 1000 together with the battery module 10. While FIG. 2 illustrates an example in which the battery pack 1000 includes one battery module 10 and one battery management system 100, the number of battery modules 10 and battery management systems 100 included in the battery pack 1000 is not limited to the number shown in FIG. 2. Similarly, the number of secondary batteries 11 included in the battery module 10 is not limited to the number shown in FIG. 2.

A battery module and a secondary battery included in a battery pack of the present invention are described. A secondary battery subject to degradation diagnosis by the battery management system 100 of the present invention includes lithium iron phosphate as the positive electrode active material of the positive electrode.

A lithium secondary battery with lithium iron phosphate as a positive electrode active material includes a plateau interval in which, in a capacity-voltage graph corresponding to voltage as a function of capacity, the amount of change in voltage is zero or close to zero in a certain capacity interval, despite a change in capacity according to charge and discharge. In the prior art, there is no way to diagnose degradation of a secondary battery applied with lithium iron phosphate. The present invention provides a battery management system and a battery pack including the system that can diagnose the degradation of such a secondary battery.

In exemplary embodiments, the lithium iron phosphate may be a compound of the Chemical Formula 1 below.

[Chemical Formula 1] $\qquad Li_{1+a}Fe_{1-x}M_x(PO_{4-b})X_b$

In Chemical Formula 1, M includes one or more elements selected from the group consisting of Al, Mg, Ni, Co, Mn, Ti, Ga, Cu, V, Nb, Zr, Ce, In, Zn, and Y, and X includes one or more elements selected from the group consisting of F, S, and N, and a, b, and x are - $0.5 \leq a \leq 0.5$, $0 \leq b \leq 0.1$, and $0 \leq x \leq 0.5$, respectively)

For example, the lithium iron phosphate may be $LiFePO_4$.

In exemplary embodiments, the negative electrode comprising the secondary battery of the present invention may include a graphite-based negative electrode active material as the negative electrode active material, and more specifically, the graphite-based negative electrode active material may be included in an amount of 50 wt% to 100 wt% with respect to the total weight of the negative electrode active material. In response to a change in the state of charge or depth of discharge, the graphite-based negative electrode active material changes the potential of the negative electrode. In other words, in the case of a negative electrode including a graphite-based negative electrode active material, the correlation graph between the State Of Charge (SOC) or Depth of Discharge (DOD) and the negative electrode potential does not include a plateau interval where the negative electrode potential does not change in response to a change in the state of charge or depth of discharge, and therefore, a secondary battery having a negative electrode including a graphite-based negative electrode active material is suitable for application of the degeneration diagnosis method of the present invention.

Specific examples of such graphite-based negative electrode active materials include synthetic graphite, natural graphite, graphitized carbon fiber, amorphous carbon, carbonaceous materials such as low-crystalline carbon and high-crystalline carbon, and composites including metallic compounds and carbonaceous materials. Low-crystalline carbons include soft carbon and hard carbon, and high-crystalline carbons include natural graphite, kish graphite, and pyrolytic carbon, mesophase pitch based carbon fiber, meso-carbon microbeads, mesophase pitches, and high temperature calcined carbons such as petroleum or coal tar pitch derived cokes.

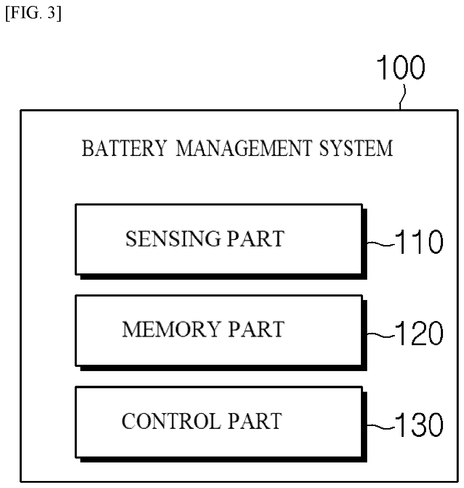

A specific configuration of the battery management system 100 will be described with reference to FIG. 3. FIG. 3 is a block diagram schematically illustrating a battery management system according to an exemplary embodiment of the present invention.

Referring to FIG. 3, the battery management system 100 may include a sensing part 110, a memory part 120, and a control part 130.

The sensing part 110 may be configured to measure a voltage of the secondary battery 11 included in the battery module 10. That is, the sensing part 110 may be configured to measure a voltage of each of the secondary batteries 11 included in the battery module 10.

For example, in the embodiment illustrated in FIG. 2, the sensing part 110 can measure a voltage when the first secondary battery C1, the second secondary battery C2, the third secondary battery C3, and the fourth secondary battery C4 included in the battery module 10 are discharged, respectively. Specifically, the sensing part 110 may measure the voltage of the first secondary battery C1 through the first sensing line SL1 and the second sensing line SL2, and the voltage of the second secondary battery C2 through the second sensing line SL2 and the third sensing line SL3. Further, the sensing part 110 may measure the voltage of the third secondary battery C3 through the third sensing line SL3 and the fourth sensing line SL4, and may measure the voltage of the fourth secondary battery C4 through the fourth sensing line SL4 and the fifth sensing line SL5.

Further, the sensing part 110 is configured to measure the open circuit voltage (OCV) of the secondary battery 11. That is, the sensing part 110 is configured to measure both the voltage of the secondary battery 11 and the open circuit voltage. Further, the sensing part 110 is configured to measure the voltage of the secondary battery when the secondary battery is charged and discharged, and is configured to measure the open circuit voltage of the secondary battery 11 for determining degradation.

The secondary battery undergoes degradation with repeated charge/discharge cycles, and the sensing part 110 may be configured to measure the voltage of the secondary battery while the secondary battery 11 is being charged and discharged, and to measure the open circuit voltage of the secondary battery 11 at the end of each charge/discharge cycle for data collection for diagnosing degradation. One charge/discharge cycle may be defined as the process of charging the secondary battery 11 in a discharged state and then discharging the secondary battery 11 in a charged state.

The sensing part 110 can measure the open circuit voltage of each secondary battery 11 whenever the voltage of the secondary battery being measured reaches a reference discharge voltage during N (N is an integer greater than or equal to 2) charge/discharge cycles for the secondary battery. Here, the reference discharge voltage may be a voltage preset and stored by a user or the like to enable the sensing part 110 to measure the open circuit voltage. In other words, the reference discharge voltage is a reference value for the open circuit voltage of the secondary battery 11 to be measured by the sensing part 110, and may provide a period when the sensing part 110 should measure the open circuit voltage of the secondary battery 11. For example, the reference discharge voltage may be 2.5V. However, it is not limited to this.

The sensing part 110 may be configured to measure the voltage of a plurality of secondary batteries 11 as they discharge, and to measure the open circuit voltage of a corresponding secondary battery 11 whenever the measured voltage of the secondary battery 11 reaches the reference discharge voltage. The sensing part 110 may be configured to measure the open circuit voltage of the secondary battery 11 during rest, after the secondary battery 11 has reached the reference discharge voltage. By resting, it means a period of time after the secondary battery has finished discharging, during which it waits for a period of time before charging for the next charge/discharge cycle. As a non-limiting example, the open circuit voltage may be measured within 1 second after the end of the discharge, more specifically within 1 minute after 3 seconds, and more specifically within 30 seconds after 5 seconds.

For example, in the embodiment shown in FIG. 2, it is assumed that a reference discharge voltage is set to Vs [V] for each of the secondary batteries 11. At this time, the sensing part 110 can measure the open circuit voltage of the first secondary battery C1 when the voltage of the first secondary battery C1 reaches Vs by discharging. Similarly, when the respective voltage of the second secondary battery C2, the third secondary battery C3, and the fourth secondary battery C4 reaches Vs, the sensing part 110 can measure the open circuit voltage of the secondary battery that has reached Vs.

In one particular example, the sensing part 110 may include a voltage sensor (not shown). The voltage sensor is electrically connected to a positive terminal and a negative terminal of the secondary battery 11. The voltage sensor may be installed in the charge and discharge path of the secondary battery. In addition, the sensing part 110 may further include a current sensor (not shown). The current sensor may be configured to measure the current in the secondary battery at predetermined times while the secondary battery is being charged or discharged.

The memory part 120 may be operably coupled to the sensing part 110. The memory part 120 may be configured to store open circuit voltage measurements taken by the sensing part 110, as well as other sensing information. The memory part 120 may also store data or programs required for each component of the battery management system 100 to perform operations and functions, or data generated in the course of performing operations and functions.

The memory part 120 may be configured to store the measured open circuit voltage of the secondary battery 11 at the end of each charge/discharge cycle, while repeating the charge/discharge. In one example, the memory part 120 may be configured to store the measured open-circuit voltage value for the secondary battery 11 at the end of each charge/discharge cycle, such as storing the measured open-circuit voltage V1 when the reference discharge voltage is reached in the discharge process of the first charge/discharge cycle, storing the measured open-circuit voltage V2 when the reference discharge voltage is reached in the discharge process of the second charge/discharge cycle, and so on.

The memory part 120 is not particularly limited in type as long as it is a means for storing information of a publication known to be capable of recording, erasing, and updating data. In one example, the memory part 120 may include one or more type of storage medium selected from the group consisting of a flash memory type, a hard disk type, a solid state disk type, a silicon disk drive type, a multimedia card micro type, random access memory (RAM), a static random access memory (SRAM), a read-only memory (ROM), an electrically erasable programmable read-only memory (EEPROM), and a programmable read-only memory (PROM).

The control part 130 may receive the open circuit voltage measured by the sensing part 110. The control part 130 may be configured to communicate electrical signals to and from the memory part 120 within the battery management system 100 to receive open circuit voltage data stored in the memory part 120 based on charge/discharge cycles.

The control part 130 may be configured to calculate, from the memory part 120, an amount of change in each open circuit voltage measured over a charge/discharge cycle, and may be configured to determine that the secondary battery is degraded if the amount of change in the open circuit voltage due to charge/discharge cycles of the secondary battery satisfies Condition 1 below for at least five charge/discharge cycles.

[Condition 1]

$$V_{n-1} - V_n < 0.002V$$

(In Condition 1, $V_{n-1}$ represents the open circuit voltage measured during the $(n-1)^{th}$ charge-discharge cycle, $V_n$ represents the open circuit voltage measured during the $n^{th}$ charge/discharge cycle, and n represents a random integer)

That is, the control part 130 determines whether the amount of change in the open circuit voltage $V_{n-1}$ measured in the previous charge/discharge cycle and the open circuit voltage $V_n$ measured in the current charge/discharge cycle is less than 0.002 V, and if the amount of change in such open circuit voltage satisfies Condition 1 for at least five charge/discharge cycles, the corresponding secondary battery may be determined to have degraded.

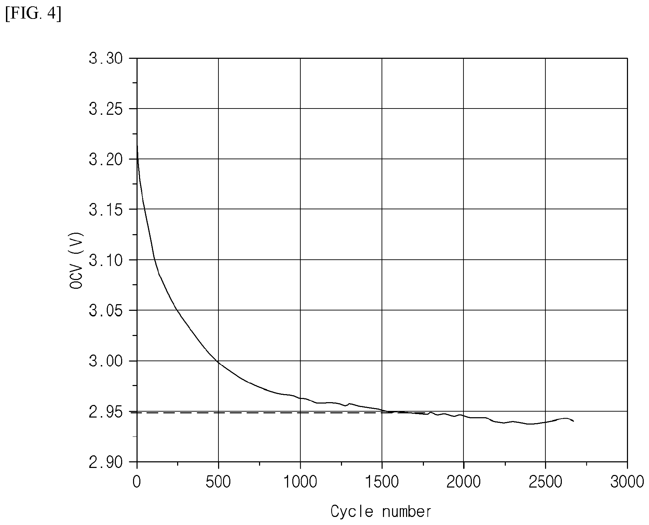

FIG. 4 is a graph illustrating an exemplary measurement of an open circuit voltage over a charge/discharge cycle calculated by the battery management system 100 according to an exemplary embodiment of the present invention. The control part 130 may generate the graph shown in FIG. 4 from open circuit voltage data stored in the memory part 120. The graph in FIG. 4 shows a relationship between the cycle number and the open circuit voltage, wherein the open circuit voltage gradually decreases as the charge/discharge cycle progresses, and the amount of change in the voltage gradually becomes smaller and smaller, and the amount of change in the open circuit voltage approaches zero after about 1500 cycles.

Compared to spinel or layered positive electrode active materials, the Olivine structure of lithium phosphate is stable to structural changes due to degradation or deterioration, and as a result, the voltage of lithium phosphate does not change significantly with charge and discharge. Therefore, in a secondary battery with a positive electrode including lithium phosphate, the voltage of the secondary battery is often determined by the potential difference of the negative electrode. In other words, the measured open circuit voltage of a lithium phosphate-based secondary battery is easy to determine the potential difference of the negative electrode.

Accordingly, in order to diagnose the degradation of a secondary battery having a lithium iron phosphate positive electrode, if the amount of change in the open circuit voltage of the secondary battery measured in the resting phase after discharge during the progress of a charge/discharge cycle is less than 0.002V for a certain cycle, the negative electrode is considered to be degraded, and the degradation of the secondary battery can be determined.

In a lithium secondary battery having a positive electrode with lithium iron phosphate as the positive electrode active material, as charge/discharge cycles are accumulated, due to the difference in charge and discharge rates of the positive electrode and negative electrode, lithium may be charged on a non-facing part of the negative electrode that is not facing the positive electrode. The non-facing part of the negative electrode that is not facing the positive electrode exists because the negative electrode is cut larger than the positive electrode, and typically the edge part of the negative electrode becomes the non-facing part. If this phenomenon of lithium charging in the non-facing part occurs continuously, the lithium required for charging and discharging accumulates on the non-facing part, reducing the capacity of the battery, and lithium precipitation may cause safety issues.

In a secondary battery with lithium iron phosphate as the positive electrode active material, the potential difference of the negative electrode can be determined through the behavior of the open circuit voltage, and when the negative electrode is degraded due to the reduction of the available lithium due to the charging of lithium on the non-facing part not facing the positive electrode, the potential of the negative electrode does not change over a certain number of charge/discharge cycles, so that the present invention can diagnose whether the secondary battery is degraded due to the charging of lithium on the non-facing part through the behavior of the open circuit voltage of the secondary battery.

The control part 130 may optionally include processors, application-specific integrated circuits (ASICs), other chipsets, logic circuits, registers, communication modems, data processing devices, and the like known in the art to execute various control logic performed by the battery management system 100 according to one embodiment of the present invention. Further, when the control logic is implemented as software, the control part 130 may be implemented as a set of program modules. Here, the program modules may be stored in the memory part, and may be executed by a processor. For example, the control part 130 is a processor provided in the battery management system 100 according to one embodiment of the present invention, and can provide the determined degradation status of the secondary battery 11 to a user via an output device such as a display device. The control part 130 may also provide a replacement or warning alarm of the secondary battery 11 to the user via an external notification device based on the determination result of whether the secondary battery 11 is degraded.

In a secondary battery having a positive electrode including lithium iron phosphate as the positive electrode active material, the battery management system of the present invention has the effect of diagnosing the degradation of the secondary battery by considering the degradation of the negative electrode as the degradation of the secondary battery from the amount of change in the open circuit voltage as the charge/discharge cycle progresses, using the feature that the potential difference of the negative electrode is represented by the open circuit voltage of the secondary battery.

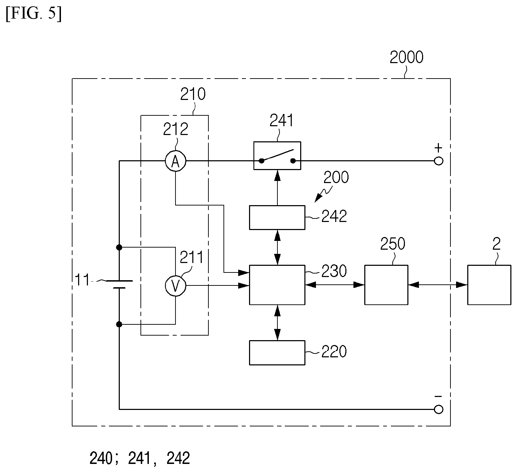

FIG. 5 is a schematic diagram of a battery pack including a battery management system, according to another exemplary embodiment of the present invention. Referring to FIG. 5, the battery management system 200 may further include a switching part 240 for turning an electrical connection between the secondary battery 11 and the charger on and off, and an interface part 250.

The switching part 240 may include a switch 241 and a switch driver 242. The switch 241 is installed in the path of the current for charging and discharging the secondary battery 11. While the switch 241 is turned on, charging and discharging of the secondary battery 11 is possible. The switch 241 may be a mechanical relay that is turned on and off by the magnetic force of a coil, or it may be a semiconductor switch such as a metal oxide semiconductor field effect transistor (MOSFET). Charging and discharging of the secondary battery 11 is stopped while the switch 241 is turned off. In one embodiment, the switch 241 may be turned on in response to a first control signal and turned off in response to a second control signal.

The switch driver 242, which may be electrically connected to the switch 241 and the control part 230, is configured to selectively output a first control signal or a second control signal to the switch 241 in response to a command from the control part 230. The control part 230 may command the switch driver 242 to turn the switch 241 on or off when at least one of the predetermined events occurs.

The interface part 250 is configured to support wired or wireless communication between the control part 230 and a upper-level controller 2 (e.g., an electronic control unit (ECU)) of the electrical system 1. The wired communication may be, for example, Controller Area Network (CAN) communication, and the wireless communication may be, for example, Zigbee or Bluetooth communication. Of course, the type of communication protocol is not particularly limited, as long as it supports wired or wireless communication between the control part 230 and the upper-level controller 2.

The interface part 250 may include an output device (not shown), such as a display, speaker, or the like, to provide the results of the process regarding the degradation state of the secondary battery 11 performed by the control part 230 in a form recognizable to the user. The interface part 250 may include an input device (not shown), such as a mouse, keyboard, or the like, for receiving data input from a user.

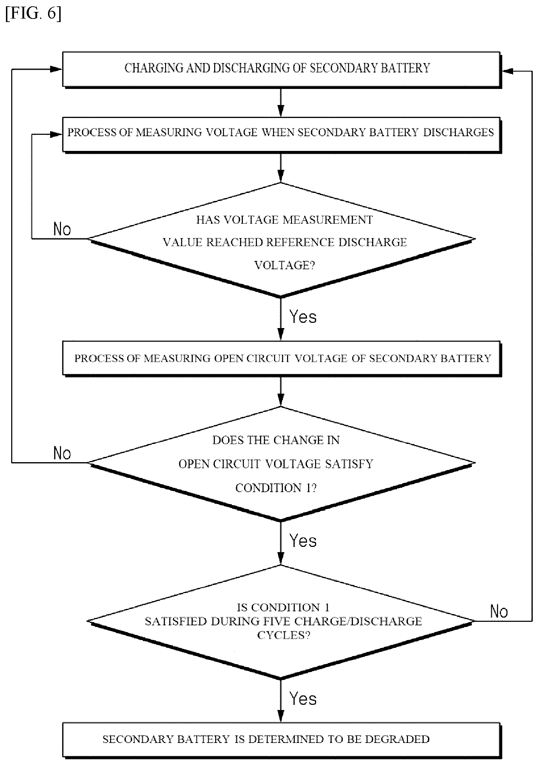

FIG. 6 is a flowchart illustrating an exemplary method for diagnosing degradation of a secondary battery according to another exemplary embodiment of the present invention.

Referring to FIG. 6, a method for diagnosing degradation of a secondary battery according to the present invention includes (A) repeatedly charging and discharging the secondary battery, measuring a voltage at which the secondary battery discharges, and measuring an open circuit voltage of the secondary battery whenever the measured voltage reaches a reference discharge voltage; and (B) determining that the secondary battery is degraded if the amount of change in the open circuit voltage satisfies Condition 1 below for at least five charge/discharge cycles.

[Condition 1]

$$V_{n-1} - V_n < 0.002V$$

(In Condition 1, $V_{n-1}$ represents the open circuit voltage measured during the $(n-1)^{th}$ charge-discharge cycle, $V_n$ represents the open circuit voltage measured during the $n^{th}$ charge/discharge cycle, and n represents a random integer)

The secondary battery to which the method of diagnosing the degradation of the secondary battery according to the present invention is applied is as described above.

The process (A) is a process of collecting data to diagnose whether the secondary battery is degraded. The method of diagnosing degradation according to the present invention includes: performing charge/discharge cycles of the secondary battery, measuring an open circuit voltage for each charge/discharge cycle, and collecting an open circuit voltage corresponding to a number of charge/discharge cycles.

Thus, the process (A) includes measuring an open circuit voltage of the secondary battery at the end of one charge/discharge cycle for the secondary battery. The timing of the measurement of the open circuit voltage may be during a rest period until the next charge, after the secondary battery has reached a reference discharge voltage.

The process (B) is a process for diagnosing whether a secondary battery is degraded based on the amount of change in the open circuit voltage over charge/discharge cycles collected through the process (A). Specifically, the process includes determining that the secondary battery is degraded if the condition that the difference between the open circuit voltage of the battery measured in the n-1$^{th}$ charge/discharge cycle and the voltage of the battery measured in the n$^{th}$ charge/discharge cycle is less than 0.002 V is satisfied for five charge/discharge cycles.

Referring to FIG. 6, the process (A) includes measuring the voltage of the secondary battery and the open circuit voltage while repeatedly charging and discharging the secondary battery.

Repeated charging and discharging of a secondary battery means charging a secondary battery in a discharged state and discharging a secondary battery in a charged state, setting this as a single charge/discharge cycle, and repeating such charge/discharge cycle several times.

In one charge/discharge cycle, the voltage of the secondary battery can be measured while charging the secondary battery and then discharging the secondary battery from the charged state. The voltage measurement of the secondary battery may be performed at regular temporal intervals.

While monitoring whether the measured voltage of the secondary battery reaches the reference discharge voltage, a discharge and measuring the voltage of the secondary battery until the voltage measurement of the secondary battery reaches the reference discharge voltage is performed.

If the voltage measurement reaches the reference discharge voltage, the discharge of the secondary battery is terminated, allowing the secondary battery to rest. Resting means to stop supplying current to the secondary battery for charging and discharging. After this discharge, the open circuit voltage of the secondary battery is measured at rest.

In an exemplary embodiment, the charging and discharging method in the process (A) may include a charging and discharging method applicable to the secondary battery, and as non-limited examples, a constant current (CC) method, a constant voltage (CV) method, a constant power (CP) method, a combined CC-CV method, and a CP-CV method may be listed, and an appropriate charging and discharging method may be selected according to the type of secondary battery. For example, a CP charging and discharging method can be selected for a secondary battery for ESS. The charge and discharge rate (C-rate, CP-rate) is also not specifically limited, and a suitable range of charge and discharge rates can be selected by considering the charge and discharge characteristics of the electrode.

As shown in FIG. 4, as the charge/discharge cycle of the secondary battery progresses, the change in the open circuit voltage of the secondary battery gradually decreases, and eventually the change in open circuit voltage becomes less than 0.002V.

In determining whether a secondary battery has degraded, based on the amount of change in the open circuit voltage, and specifically, if the condition that the amount of change between the open circuit voltage of the battery measured in the n-1st charge/discharge cycle and the open circuit voltage of the battery measured in the $n^{th}$ charge/discharge cycle is less than 0.002V is satisfied for at least five charge/discharge cycles, the present invention determines the secondary battery as degraded.

The present invention will now be described in more detail by way of example. However, the following examples are intended to illustrate the invention and are not intended to limit the scope of the invention.

**Example**

(The process of collecting the open circuit voltage for each charge/discharge cycle of a secondary battery)

A battery cell provided with a negative electrode of 100% synthetic graphite as the negative electrode active material and a positive electrode of 100% $LiFePO_4$ as the positive electrode active material was prepared. The battery cell was charged to 3.65V at a rate of 1CP-rate and discharged to 2.5V at a rate of 1CP-rate. During the discharge of the battery cell, the voltage of the battery cell was monitored, and the discharge was terminated when the voltage of the battery cell was 2.5V. Five seconds after the end of the discharge, the open circuit voltage of the battery cell was measured and the result was stored as $V_1$.

Then, charge and discharge were repeated n times in the same way as above, but each open circuit voltage measured in each charge/discharge cycle was stored as $V_2$, $V_3$ ...$V_n$.

(The process of determining whether a secondary battery is degraded)

While repeatedly charging and discharging the battery cell, the difference between the open circuit voltage $V_{n-1}$ measured in the previous charge/discharge cycle and the open circuit voltage $V_n$ measured in the current charge/discharge cycle was calculated, and when the number of times the difference in the open circuit voltage was less than 0.002 V accumulated five times, the charging and discharging of the battery cell was terminated, and the battery cell was determined to be degraded.

**Experimental Example 1: Identifying lithium on a non-facing part of the negative electrode not facing the positive electrode**

In a battery cell determined to be degraded according to the above example, the negative electrode was obtained by opening the battery case and disassembling the electrode assembly housed therein. Upon observation of the negative electrode, it was found that lithium was precipitated on the non-facing part. Based on these results, it appears that the degradation diagnosis method according to the present invention can diagnose the accumulation of lithium at the area of the negative electrode not facing the positive electrode.

**Experimental Example 2: Confirming capacity retention rate**

For the battery cell of the example, the discharge capacity 1 was measured in the first charge/discharge cycle. The discharge capacity 2 of the battery cell was measured in the charge/discharge cycle in which the battery cell was determined to be degraded according to the example. Then, the capacity retention rate was calculated according to Equation 1 below.

$$\text{Equation 1: (discharge capacity } 2 \times 100)/ \text{ discharge capacity } 1$$

The calculated capacity retention rate was 83%. Generally, a secondary battery with a capacity retention rate of 80% is considered to be degraded, and the degradation diagnosis method according to the present invention is analyzed to be effective for the degradation diagnosis of a secondary battery having lithium iron phosphate as the positive electrode active material.

The examples of the present invention described above are not only implemented through the battery management system 100 and the method, but may also be implemented through a program that implements a function corresponding to the configuration of an embodiment of the present invention or a recording medium on which the program is recorded, and such implementation can be easily implemented by an expert in the technical field to which the present invention belongs from the description of the embodiments described above.

Although the present invention has been described above by way of limited embodiments and drawings, the present invention is not limited thereby, and various modifications and variations may be made by one having ordinary knowledge in the technical field to which the present invention belongs, within the equitable scope of the claims of the patent set forth below.

Furthermore, the present invention described above is not limited by the foregoing embodiments and accompanying drawings, as various substitutions, modifications, and changes can be made without departing from the technical ideas of the present invention by one of ordinary skill in the art to which the present invention belongs, and all or portions of each embodiment can be optionally combined so that various variations can be made within the scope of the appended claims.

**Claims**

1. A battery management system : (100) for diagnosing the degradation of a secondary battery (11) equipped with a positive electrode including lithium iron phosphate as a positive electrode active material, comprising:

   a sensing part (110) configured to measure the voltage and open circuit voltage of a secondary battery;
   a memory part (120) configured to store the open circuit voltage measured by the sensing part; **characterised in that** the battery management system further comprises
   a control part (130) configured to determine that the secondary battery is degraded if the amount of change in the open circuit voltage due to charge/discharge cycles of the secondary battery satisfies Condition 1 below for at least five charge/discharge cycles.

$$[\text{Condition } 1]$$

$$V_{n-1} - V_n < 0.002V$$

   wherein in Condition 1, $V_{n-1}$ represents the open circuit voltage measured during the $(n-1)^{th}$ charge-discharge cycle, $V_n$ represents the open circuit voltage measured during the $n^{th}$ charge/discharge cycle, and n represents a random integer.

2. The battery management system of claim 1, wherein
   the sensing part is configured to measure the voltage of the secondary battery during discharge, and to measure the open circuit voltage of the secondary battery each time the measured voltage reaches a reference discharge voltage.

3. The battery management system of claim 2, wherein
   the sensing part is configured to measure the open circuit voltage of the secondary battery during the rest period after reaching the reference discharge voltage.

4. The battery management system of claim 1, wherein
   the sensing part is configured to measure the open circuit voltage of the secondary battery at the end of each charge/discharge cycle.

5. The battery management system of claim 1, further comprising
   a switching part (240) that turns the electrical connection between the secondary battery and the charger on and off.

6. A battery pack (1000) comprising:

   a battery management system according to claim 1; and
   a plurality of secondary batteries (11).

7. The battery pack of claim 6, wherein
the secondary battery includes a graphite-based negative electrode active material as the negative electrode active material, comprising 50 to 100% by weight of the total weight of the negative electrode active material included in the negative electrode.

8. A method for diagnosing the degradation of a secondary battery equipped with a positive electrode including lithium iron phosphate as a positive electrode active material, comprising:

(A) a process of repeatedly charging and discharging a secondary battery, while measuring the voltage when the secondary battery discharges and measuring the open circuit voltage of the secondary battery whenever the measured voltage reaches a reference discharge voltage; **characterised in that** the process further comprises (B) a process of determining that a secondary battery is degraded when the change in open circuit voltage satisfies Condition 1 below for at least five charge/discharge cycles.

$$[\text{Condition 1}]$$

$$V_{n-1} - V_n < 0.002V$$

wherein in Condition 1, $V_{n-1}$ represents the open circuit voltage measured during the $(n-1)^{th}$ charge-discharge cycle, $V_n$ represents the open circuit voltage measured during the $n^{th}$ charge/discharge cycle, and n represents a random integer.

9. The method for diagnosing the degradation of a secondary battery of claim 8, wherein
the process (A) includes measuring the open circuit voltage of the secondary battery during the rest period after reaching the reference discharge voltage.

10. The method for diagnosing the degradation of a secondary battery of claim 8, wherein
the process (A) includes measuring the open circuit voltage of the secondary battery at the end of each charge/-discharge cycle.

11. The method for diagnosing the degradation of a secondary battery of claim 8, wherein
the secondary battery includes 50 to 100% graphite-based negative electrode active material as the negative electrode active material.

**Patentansprüche**

1. Batterieverwaltungssystem (100) zum Diagnostizieren der Verschlechterung einer Sekundärbatterie (11), die mit einer Positivelektrode ausgestattet ist, die Lithium-Eisenphosphat als aktives Material der Positivelektrode einschließt, umfassend:

einen Abtastteil (110), der so ausgebildet ist, dass er die Spannung und Leerlaufspannung einer Sekundärbatterie misst;
einen Speicher (120), der so ausgebildet ist, dass er die vom Abtastteil gemessene Leerlaufspannung speichert; **dadurch gekennzeichnet, dass** das Batterieverwaltungssystem weiter einen Steuerteil (130) umfasst, der so ausgebildet ist, dass er bestimmt, dass sich die Sekundärbatterie verschlechtert hat, wenn die Menge von Änderung in der Leerlaufspannung infolge von Lade-/Entladezyklen der Sekundärbatterie die unten stehende Bedingung 1 für mindestens fünf Lade-/Entladezyklen erfüllt.

$$[\text{Bedingung 1}]$$

$$V_{n-1} - V_n < 0{,}002 \ V$$

wobei in Bedingung 1 $V_{n-1}$ die während des (n-1)-ten Lade-/Entladezyklus gemessene Leerlaufspannung darstellt, $V_n$ die während des n-ten Lade-/Entladezyklus gemessene Leerlaufspannung darstellt und n eine zufällige ganze Zahl darstellt.

**2.** Batterieverwaltungssystem nach Anspruch 1, wobei
der Abtastteil so ausgebildet ist, dass er die Spannung der Sekundärbatterie während des Entladens misst und die Leerlaufspannung der Sekundärbatterie immer dann misst, wenn die gemessene Spannung eine Referenz-Entladespannung erreicht.

**3.** Batterieverwaltungssystem nach Anspruch 2, wobei
der Abtastteil so ausgebildet ist, dass er die Leerlaufspannung der Sekundärbatterie während der restlichen Zeitspanne nach Erreichen der Referenz-Entladespannung misst.

**4.** Batterieverwaltungssystem nach Anspruch 1, wobei
der Abtastteil so ausgebildet ist, dass er die Leerlaufspannung der Sekundärbatterie am Ende von jedem Lade-/Entladezyklus misst.

**5.** Batterieverwaltungssystem nach Anspruch 1, weiter umfassend
einen Umschaltteil (240), der die elektrische Verbindung zwischen der Sekundärbatterie und dem Ladegerät ein- und ausschaltet.

**6.** Batteriepack (1000), umfassend:

ein Batterieverwaltungssystem nach Anspruch 1; und
eine Vielzahl von Sekundärbatterien (11).

**7.** Batteriepack nach Anspruch 6, wobei
die Sekundärbatterie ein graphitbasiertes aktives Material der Negativelektrode einschließt, das 50 bis 100 Gewichts-% des Gesamtgewichts des aktiven Materials der Negativelektrode, das in der Negativelektrode eingeschlossen ist, umfasst.

**8.** Verfahren zum Diagnostizieren der Verschlechterung einer Sekundärbatterie, die mit einer Positivelektrode ausgestattet ist, die Lithium-Eisenphosphat als aktives Material der Positivelektrode einschließt, umfassend:

(A) einen Prozess von wiederholtem Laden und Entladen einer Sekundärbatterie, wobei die Spannung gemessen wird, wenn die Sekundärbatterie entlädt, und die Leerlaufspannung der Sekundärbatterie gemessen wird, wenn die gemessene Spannung eine Referenz-Entladespannung erreicht;

**dadurch gekennzeichnet, dass** der Prozess weiter Folgendes umfasst:

(B) einen Prozess des Bestimmens, dass sich eine Sekundärbatterie verschlechtert hat, wenn die Änderung der Leerlaufspannung die unten stehende Bedingung 1 für mindestens fünf Lade-/Entladezyklen erfüllt.

$$[\text{Bedingung 1}]$$
$$V_{n-1} - V_n < 0{,}002\ V$$

wobei in Bedingung 1 $V_{n-1}$ die während des (n-1)-ten Lade-/Entladezyklus gemessene Leerlaufspannung darstellt, $V_n$ die während des n-ten Lade-/Entladezyklus gemessene Leerlaufspannung darstellt und n eine zufällige ganze Zahl darstellt.

**9.** Verfahren zum Diagnostizieren der Verschlechterung einer Sekundärbatterie nach Anspruch 8, wobei
der Prozess (A) das Messen der Leerlaufspannung der Sekundärbatterie während der restlichen Zeitspanne nach Erreichen der Referenz-Entladespannung einschließt.

**10.** Verfahren zum Diagnostizieren der Verschlechterung einer Sekundärbatterie nach Anspruch 8, wobei
der Prozess (A) das Messen der Leerlaufspannung der Sekundärbatterie am Ende von jedem Lade-/Entladezyklus einschließt.

**11.** Verfahren zum Diagnostizieren der Verschlechterung einer Sekundärbatterie nach Anspruch 8, wobei
die Sekundärbatterie 50 bis 100 % graphitbasiertes aktives Material der Negativelektrode als das aktive Material der Negativelektrode einschließt.

**Revendications**

1. Système (100) de gestion de batterie pour le diagnostic de la dégradation d'une batterie secondaire (11) équipée d'une électrode positive incluant du phosphate de fer lithié en tant que matériau actif d'électrode positive, comprenant :

   une unité de détection (110) configurée pour mesurer la tension et la tension en circuit ouvert d'une batterie secondaire ;
   une unité de mémoire (120) configurée pour stocker la tension en circuit ouvert mesurée par l'unité de détection ;
   **caractérisé en ce que** le système de gestion de batterie comprend en outre une unité de commande (130) configurée pour déterminer que la batterie secondaire est dégradée si la variation de la tension en circuit ouvert due à des cycles de charge/décharge de la batterie secondaire satisfait à la Condition 1 ci-dessous pour au moins cinq cycles de charge/décharge.

   [Condition 1]

   $$V_{n-1} - V_n < 0{,}002V$$

   dans lequel, dans la Condition 1, $V_{n-1}$ représente la tension en circuit ouvert mesurée pendant le $(n-1)^{ième}$ cycle de charge-décharge, $V_n$ représente la tension en circuit ouvert mesurée pendant le $n^{ième}$ cycle de charge/décharge, et n représente un nombre entier quelconque.

2. Système de gestion de batterie selon la revendication 1, dans lequel
   l'unité de détection est configurée pour mesurer la tension de la batterie secondaire pendant une décharge, et pour mesurer la tension en circuit ouvert de la batterie secondaire chaque fois que la tension mesurée atteint une tension de décharge de référence.

3. Système de gestion de batterie selon la revendication 2, dans lequel
   l'unité de détection est configurée pour mesurer la tension en circuit ouvert de la batterie secondaire pendant la période de repos après avoir atteint la tension de décharge de référence.

4. Système de gestion de batterie selon la revendication 1, dans lequel
   l'unité de détection est configurée pour mesurer la tension en circuit ouvert de la batterie secondaire à la fin de chaque cycle de charge/décharge.

5. Système de gestion de batterie selon la revendication 1, comprenant en outre
   une unité de commutation (240) qui établit et coupe la connexion électrique entre la batterie secondaire et le chargeur.

6. Bloc-batterie (1000) comprenant :

   un système de gestion de batterie selon la revendication 1 ; et
   une pluralité de batteries secondaires (11).

7. Bloc-batterie selon la revendication 6, dans lequel
   la batterie secondaire inclut un matériau actif d'électrode négative à base de graphite en tant que matériau actif d'électrode négative, comprenant 50 à 100 % en poids du poids total du matériau actif d'électrode négative inclus dans l'électrode négative.

8. Procédé de diagnostic de la dégradation d'une batterie secondaire équipée d'une électrode positive incluant du phosphate de fer lithié en tant que matériau actif d'électrode positive, comprenant :

   (A) un procédé consistant à charger et décharger à plusieurs reprises une batterie secondaire, tout en mesurant la tension lorsque la batterie secondaire se décharge et en mesurant la tension en circuit ouvert de la batterie secondaire chaque fois que la tension mesurée atteint une tension de décharge de référence ;
   **caractérisé en ce que** le procédé comprend en outre
   (B) un procédé consistant à déterminer qu'une batterie secondaire est dégradée lorsque la variation de la tension en circuit ouvert satisfait à la Condition 1 ci-dessous pour au moins cinq cycles de charge/décharge.

[Condition 1]

$$V_{n-1} - V_n < 0,002V$$

dans lequel, dans la Condition 1, $V_{n-1}$ représente la tension en circuit ouvert mesurée pendant le $(n-1)^{ième}$ cycle de charge-décharge, $V_n$ représente la tension en circuit ouvert mesurée pendant le $n^{ième}$ cycle de charge/décharge, et n représente un nombre entier quelconque.

9. Procédé de diagnostic de la dégradation d'une batterie secondaire selon la revendication 8, dans lequel le procédé (A) inclut la mesure de la tension en circuit ouvert de la batterie secondaire pendant la période de repos après avoir atteint la tension de décharge de référence.

10. Procédé de diagnostic de la dégradation d'une batterie secondaire selon la revendication 8, dans lequel le procédé (A) inclut la mesure de la tension en circuit ouvert de la batterie secondaire à la fin de chaque cycle de charge/décharge.

11. Procédé de diagnostic de la dégradation d'une batterie secondaire selon la revendication 8, dans lequel la batterie secondaire inclut 50 à 100 % d'un matériau actif d'électrode négative à base de graphite en tant que matériau actif d'électrode négative.

[FIG. 1]

[FIG. 2]

[FIG. 3]

100

BATTERY MANAGEMENT SYSTEM

SENSING PART ~110

MEMORY PART ~120

CONTROL PART ~130

[FIG. 4]

[FIG. 5]

240; 241, 242

[FIG. 6]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220150244

- EP 3989330 A1